(19) Europäisches Patentamt / European Patent Office / Office européen des brevets

(11) EP 3 839 587 A1

(12) DEMANDE DE BREVET EUROPEEN

(43) Date de publication:
23.06.2021 Bulletin 2021/25

(51) Int Cl.:
G02B 6/12 (2006.01)          G02B 6/122 (2006.01)

(21) Numéro de dépôt: 20215584.2

(22) Date de dépôt: 18.12.2020

(84) Etats contractants désignés:
AL AT BE BG CH CY CZ DE DK EE ES FI FR GB
GR HR HU IE IS IT LI LT LU LV MC MK MT NL NO
PL PT RO RS SE SI SK SM TR
Etats d'extension désignés:
BA ME
KH MA MD TN

(30) Priorité: 20.12.2019 FR 1915344

(71) Demandeur: Commissariat à l'Energie Atomique
et aux Energies
Alternatives
75015 Paris (FR)

(72) Inventeurs:
• SCIANCALEPORE, Corrado
38054 Grenoble Cedex 09 (FR)
• EL DIRANI, Houssein
38054 Grenoble Cedex 09 (FR)
• HARTMANN, Jean-Michel
38054 Grenoble Cedex 09 (FR)

(74) Mandataire: Decobert, Jean-Pascal
Cabinet Hautier
Office Méditerranéen de Brevets d'Invention
20, rue de la Liberté
06000 Nice (FR)

(54) PROCÉDÉ DE FABRICATION DE GUIDES D'ONDE

(57) L'invention concerne un procédé de fabrication d'un guide d'onde (2a, 2b) comprenant :
- Une fourniture d'un substrat (1) comprenant un empilement d'une première couche (11) à base d'un premier matériau sur une deuxième couche (12) à base d'un deuxième matériau, et
- au moins une séquence comprenant successivement :
• Une gravure du premier matériau, de manière à définir au moins un motif (20, 22a) présentant des flancs (200, 201) de gravure,
• Un recuit de lissage assisté par hydrogène de manière à lisser les flancs (200, 201) de gravure de l'au moins un motif (20, 22a),
• Une réépitaxie du premier matériau sur le motif (20, 22a) à base du premier matériau

Fig. 2I

EP 3 839 587 A1

**Description**

**DOMAINE TECHNIQUE**

La présente invention concerne le domaine de l'optoélectronique. Elle trouve pour application particulièrement avantageuse la réalisation de guides d'onde présentant de très faibles pertes optiques par propagation.

**ETAT DE LA TECHNIQUE**

Dans le domaine de l'optique intégrée sur silicium, les guides d'ondes sont des composants essentiels. Ils forment une circuiterie optique permettant d'interconnecter différents composants optoélectroniques. Les guides d'ondes sub-micrométriques sont notamment utilisés dans des applications liées aux télécommunications optiques, à la photonique, à l'optique non-linéaire et au calcul quantique.

Les guides d'onde comprennent généralement un cœur dans lequel se propage la lumière et une gaine permettant de confiner la lumière dans le cœur, par contraste d'indice de réfraction. Pour améliorer les performances des guides d'ondes sub-micrométriques, il est important de réduire les pertes optiques occasionnées lors de la propagation de la lumière au sein de ces guides d'ondes.

Les pertes optiques sont dues à plusieurs phénomènes physiques. Il existe par exemple des pertes par absorption, soit directement au sein du matériau massif du cœur, au niveau de défauts cristallins ou d'impuretés par exemple, soit en surface de ce matériau, au niveau d'états de surface entre le cœur et la gaine du guide d'onde par exemple. Il existe également des pertes dues à des effets non-linéaires, impliquant par exemple une absorption à deux photons ou par porteurs libres. Il existe encore des pertes par diffusion survenant principalement au niveau des flancs du guide d'onde. Ces pertes par diffusion sont notamment liées à la rugosité des flancs. L'équation de Payne-Lacey ci-dessous établit la relation entre les pertes $\alpha$ et la rugosité R des flancs :

$$\alpha = \varphi^2(d)(n_1^2 - n_2^2)^2 \frac{k_0^3}{4\pi n_1} \int_0^\pi R(\beta - n_2 k_0 \cos\theta)d\theta$$

Où $\varphi$ est l'amplitude du champ électrique du mode optique au niveau des flancs du guide, d est la largeur du guide, $n\_1, n\_2$ sont respectivement les indices de réfraction du cœur et de la gaine du guide, $\beta$ est la constante de propagation du mode optique, $\theta$ est un angle de propagation du mode optique par rapport l'axe du guide.

Il apparaît que, lors de la propagation, une partie non négligeable du mode optique recouvre spatialement les flancs du guide. La rugosité des flancs induit alors un phénomène de diffusion, qui est à l'origine de pertes optiques. L'amélioration des procédés de fabrication de ces guides d'onde a permis de réduire sensiblement les pertes de propagation de la lumière dans une circuiterie optique classique à base de silicium. En particulier, l'amélioration des procédés de lithographie et de gravure permet aujourd'hui de fabriquer des guides d'ondes présentant des pertes optiques de propagation de l'ordre de 2 à 3 dB/cm. Des procédés additionnels permettent encore de diminuer ces pertes optiques.

Le document « C. Bellegarde, et al. "Improvement of sidewall roughness of submicron SOI waveguides by hydrogen plasma and annealing," IEEE Photonics Technology Letters, 30(7), pp. 591-594, April 2018 » présente par exemple un procédé de fabrication d'un guide d'onde monomode de 300 nm d'épaisseur et de 450 nm de largeur présentant des pertes optiques de 0.5 dB/cm à la longueur d'onde de 1.55 $\mu$m. Ce procédé de fabrication comprend notamment, après gravure du motif de guide d'onde, une étape de lissage des flancs de gravure par un recuit sous hydrogène. Cela permet de diminuer la rugosité des flancs de gravure. Les pertes optiques par diffusion au niveau des flancs sont ainsi diminuées.

Il existe toujours un besoin consistant à diminuer toutes les sources de pertes optiques du guide d'onde, et en particulier les pertes optiques par diffusion et/ou par absorption.

Un objet de la présente invention est de proposer un procédé de fabrication d'un guide d'onde permettant de réduire les pertes optiques.

Les autres objets, caractéristiques et avantages de la présente invention apparaîtront à l'examen de la description suivante et des dessins d'accompagnement. Il est entendu que d'autres avantages peuvent être incorporés.

**RESUME**

Pour atteindre cet objectif, un aspect de l'invention concerne un procédé de fabrication d'un guide d'onde comprenant :
Une fourniture d'un substrat comprenant un empilement d'une première couche à base d'un premier matériau sur une deuxième couche à base d'un deuxième matériau, et au moins une séquence comprenant successivement :

Une gravure du premier matériau sur toute une épaisseur de la première couche, de manière à définir au moins un motif présentant des flancs de gravure,
Un recuit de lissage assisté par hydrogène de manière à lisser les flancs de gravure de l'au moins un motif,
Une épitaxie du premier matériau sur le motif à base du premier matériau.

Le premier matériau est typiquement différent du deuxième matériau. L'épitaxie du premier matériau sur le motif dont les flancs de gravure sont préalablement lissés permet avantageusement de diminuer encore la rugosité des flancs. Les pertes optiques par diffusion dans un tel guide d'onde sont ainsi diminuées.

La séquence comprenant une gravure d'un motif, un lissage des flancs de gravure de ce motif, puis une épitaxie sur ce motif peut être répétée plusieurs fois, en totalité ou partiellement. La profondeur de gravure et l'épaisseur de matériau épitaxié peuvent être ajustées en fonction de la configuration de guide d'onde souhaitée.

Le procédé selon l'invention permet ainsi de fabriquer différents types de guide d'onde, par exemple un guide d'onde en ruban ou un guide d'onde en arête, tout en minimisant la rugosité des flancs du guide d'onde. Le procédé selon l'invention permet de fabriquer des guides d'onde présentant de très faibles pertes optiques par diffusion.

L'épitaxie du premier matériau permet également de limiter voir supprimer les impuretés au sein de ce premier matériau, qui forme typiquement le cœur du guide d'onde. Les pertes par absorption du guide d'onde fabriqué par le procédé selon l'invention sont diminuées.

## BREVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :

Les figures 1A à 1F illustrent respectivement en coupe des étapes d'un procédé de fabrication de guide d'onde selon un mode de réalisation de la présente invention.
Les figures 2A à 2I illustrent respectivement en coupe des étapes d'un procédé de fabrication de guide d'onde selon un autre mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les dimensions relatives des différentes couches et motifs du guide d'onde ne sont pas représentatives de la réalité.

## DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Avant d'entamer une revue détaillée de modes de réalisation de l'invention, il est rappelé que l'invention comprend notamment les caractéristiques optionnelles ci-après pouvant être utilisées en association ou alternativement :
Selon un exemple, la première couche présente une épaisseur inférieure ou égale à 10 nm.

Selon un exemple, le procédé comprend au moins une séquence dans laquelle le premier matériau est gravé selon une profondeur de gravure inférieure à 10 nm. Selon un exemple, le procédé comprend au moins une séquence dans laquelle le premier matériau épitaxié présente une épaisseur d'épitaxie supérieure à 50 nm. Selon un exemple, l'épaisseur d'épitaxie est au moins cinq fois, et de préférence au moins dix fois, supérieure à l'épaisseur de la première couche.

Selon un exemple, l'épitaxie est configurée de manière à ce que le premier matériau épitaxié présente une épaisseur d'épitaxie supérieure à 100 nm.

Selon un exemple, le procédé comprend au moins une épitaxie supplémentaire du premier matériau sur une épaisseur d'épitaxie inférieure à 5 nm.

Selon un exemple, le procédé comprend une première séquence comprenant :

- une première gravure du premier matériau sur toute l'épaisseur de la première couche de manière à définir un premier motif,
- un premier lissage des flancs de gravure dudit premier motif, et
- une première épitaxie du premier matériau sur ce premier motif, sur une épaisseur d'épitaxie e11 supérieure à 100 nm, ladite première séquence permettant de former une première portion du guide d'onde.

Selon un exemple, le procédé comprend en outre, après la première séquence, une deuxième séquence comprenant :

- une deuxième gravure de la première portion du guide d'onde de manière à définir un deuxième motif,
- de préférence, un deuxième lissage des flancs de gravure dudit deuxième motif, et
- de préférence, une deuxième épitaxie du premier matériau sur ce deuxième motif (22a), sur une épaisseur d'épitaxie e21, e22 inférieure à 5 nm, ladite deuxième séquence permettant de former une deuxième portion du guide d'onde, de façon à obtenir par exemple un guide d'onde en arête.

Selon un exemple, l'épitaxie du premier matériau se fait sur l'ensemble des faces exposées du motif, en particulier sur les flancs et un sommet du motif.

Selon un exemple, le procédé comprend en outre, après l'au moins une séquence, une formation d'une troisième couche à base d'un troisième matériau sur le premier matériau, ledit troisième matériau présentant un indice de réfraction inférieur à celui du premier matériau et/ou supérieur à celui du deuxième matériau. Typiquement, le troisième matériau est différent du premier matériau, et de préférence aussi du deuxième matériau. Selon un exemple, le troisième matériau est un nitrure à base du premier matériau.

Selon un exemple, la troisième couche présente une épaisseur comprise entre 10 nm et 50 nm, de préférence entre 20 nm et 30 nm.

Selon un exemple, ladite formation de la troisième couche comprend un dépôt conforme du troisième matériau.

Selon un exemple, le dépôt conforme du troisième matériau comprend un dépôt chimique en phase vapeur à basse pression (LPCVD).

Selon un exemple, ladite formation de la troisième couche comprend une diffusion d'espèces dans le premier matériau à partir d'une atmosphère contrôlée.

Selon un exemple, le troisième matériau est un nitrure à base du premier matériau et la diffusion d'espèces dans le premier matériau est une diffusion d'azote à partir d'une atmosphère contrôlée présentant une concentration d'azote supérieure à 80% et de préférence égale à 100%.

Selon un exemple, la diffusion d'azote se fait à une température supérieure ou égale à 1200°C.

Selon un exemple, le procédé comprend en outre une encapsulation par une couche d'encapsulation à base du deuxième matériau, sur le premier matériau ou sur le troisième matériau.

Selon un exemple, le premier matériau est du silicium, le deuxième matériau est de l'oxyde de silicium.

Le guide d'onde fabriqué par le procédé selon l'invention peut présenter, en section, différentes formes. Dans la suite, deux modes de réalisation permettant de fabriquer respectivement un guide d'onde en ruban et un guide d'onde en arête sont décrits. Cela n'est pas limitatif de l'invention. D'autres géométries de guide d'onde, par exemple à fente ou à réseau périodique, sont évidemment possibles.

Dans les dessins d'accompagnement, seule une section du guide d'onde dans un plan yz est représentée. Cette section n'est pas nécessairement constante selon x, le long du guide d'onde. Le guide d'onde s'étend typiquement de façon continue selon une direction longitudinale x. Il guide alors la propagation du rayonnement lumineux selon x.

Le cas échéant, on entend par « réépitaxie » une reprise d'épitaxie. Cette reprise d'épitaxie est de préférence une épitaxie du premier matériau sur le premier matériau, ou une épitaxie d'un matériau à base du premier matériau sur le premier matériau.

On entend par « lissage » une diminution de la rugosité, par exemple la rugosité moyenne.

Il est précisé que, dans le cadre de la présente invention, une troisième couche intercalée entre une première couche et une deuxième couche ne signifie pas obligatoirement que les couches sont directement au contact les unes des autres, mais signifie que la troisième couche est soit directement au contact des première et deuxième couches, soit séparée de celles-ci par au moins une autre couche ou au moins un autre élément, à moins qu'il n'en soit disposé autrement.

On entend par un substrat, un film, une couche, « à base » d'un matériau M, un substrat, un film, une couche comprenant ce matériau M uniquement ou ce matériau M et éventuellement d'autres matériaux, par exemple des éléments d'alliage, des impuretés ou des éléments dopants. Le cas échéant, le matériau M peut présenter différentes stœchiométries. Ainsi, une couche en un matériau à base de nitrure de silicium peut par exemple être une couche de SiN ou une couche de $Si_3N_4$ (généralement appelé nitrure de silicium stœchiométrique).

Dans la suite, la longueur est prise selon la direction x, la largeur est prise selon la direction y, et la hauteur et la profondeur de gravure sont prises selon la direction z. L'épaisseur d'une couche est prise selon une direction normale au plan d'extension principal de la couche.

Dans la suite, un indice de réfraction est défini pour un matériau, éventuellement pour un matériau moyen, et pour une longueur d'onde.

Les termes « sensiblement », « environ », « de l'ordre de » signifient « à 10% près » ou, lorsqu'il s'agit d'une orientation angulaire, « à 10° près ». Ainsi, une direction sensiblement normale à un plan signifie une direction présentant un angle de 90±10° par rapport au plan.

L'invention va maintenant être décrite en détail au travers de quelques modes de réalisation non limitatifs.

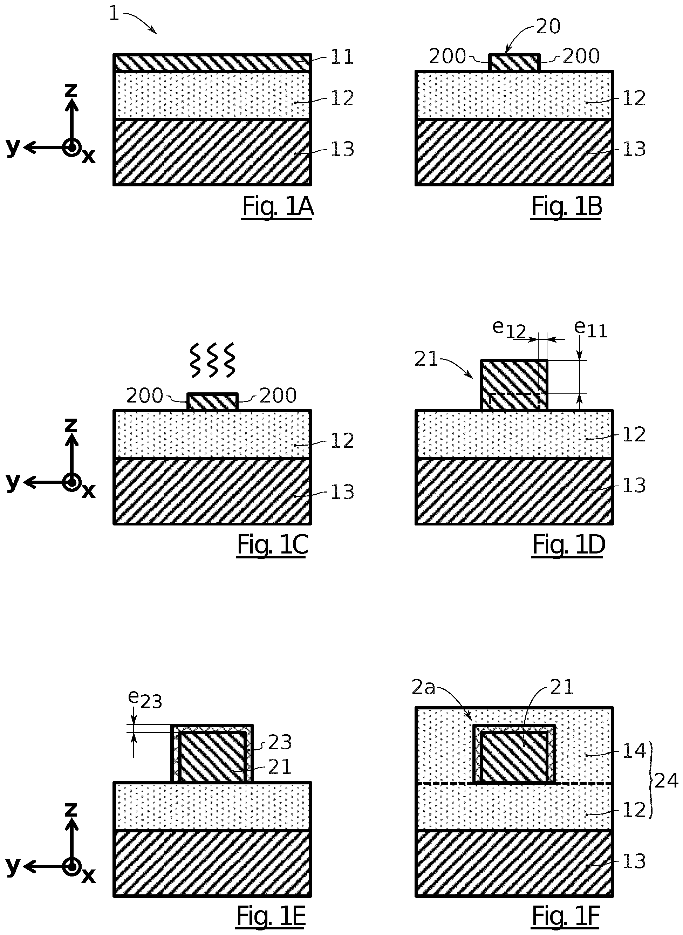

Un premier mode de réalisation du procédé est illustré aux figures 1A à 1F. Ce premier mode de réalisation permet notamment de fabriquer un guide d'onde en ruban.

Un substrat 1 est d'abord fourni (figure 1A). Ce substrat 1 est de préférence de type SOI (pour *Silicon On Insulator* c'est-à-dire silicium sur isolant). Il peut typiquement comprendre une première couche 11 de silicium, dite topSi, une deuxième couche 12 d'oxyde de silicium enterré, dite BOX (pour *Burried oxide*), et une couche 13 massive, dite bulk, en silicium. Le substrat 1 peut alternativement être de type GeOI (pour *Germanium On Insulator* c'est-à-dire germanium sur isolant) avec une première couche 11 en germanium. L'épaisseur de la première couche 11 est dans cet exemple de l'ordre de 5 nm à 10 nm. De façon plus générale, l'épaisseur de la première couche 11 peut être comprise entre 5 nm et 350 nm. Cette première couche 11 est destinée à former au moins en partie le cœur du guide d'onde. La deuxième couche 12 est destinée à former au moins en partie la gaine du guide d'onde.

Une gravure de la première couche 11 est ensuite effectuée (figure 1B). Cette gravure est typiquement une gravure sèche. Elle peut être effectuée par plasma, par exemple au sein d'un réacteur générant un plasma à couplage inductif ICP (pour *inductively coupled plasma*). La gravure du topSi peut se faire à partir d'un plasma présentant une chimie à base de HBr, par exemple une chimie Br/Cl2/He-O2. La profondeur de gravure correspond dans cet exemple à l'épaisseur du topSi.

Pour effectuer la gravure du topSi, un masque de lithographie est de préférence utilisé. Ce masque peut comprendre une couche antireflet et une couche de résine photosensible structurées sous forme de motifs de lithographie. Un tel empilement de couches est par exemple décrit en sections II.A et II.B du document « C. Bellegarde, et al. "Improvement of sidewall roughness of submicron SOI waveguides by hydrogen plasma and annealing," IEEE Photonics Technology Letters, 30(7), pp. 591-594, April 2018 ». De façon optionnelle et tel qu'indiqué dans ce document également, une première étape de lissage peut être mise en œuvre à l'issue de la lithographie et avant la gravure du topSi. Cette première étape de lissage permet notamment de lisser les flancs des motifs de lithographie en résine photosensible, avant transfert desdits motifs dans le topSi. Cette première étape de lissage peut être effectuée par plasma hydrogène.

La gravure du topSi permet de former un motif 20 à partir duquel le guide d'onde est ensuite réalisé. Ce motif 20 présente dans cet exemple une hauteur de l'ordre de 5 nm à 10 nm. Il présente des flancs 200 de gravure obtenus à l'issue de la gravure.

La figure 1C illustre une deuxième étape de lissage, configurée pour lisser les flancs 200 de gravure du motif 20. Cette deuxième étape de lissage est typiquement effectuée par recuit sous hydrogène H2. La température de recuit est inférieure à la température de fusion du matériau du motif 20. La température de recuit est en l'occurrence inférieure à 1414°C pour un motif 20 en Si. Elle peut être par exemple de 850°C, pour un recuit sous hydrogène d'environ 2 min.

Après lissage des flancs 200 de gravure, une épitaxie de silicium est effectuée sur le motif 20 (figure 1D). Cette épitaxie permet de réduire encore la rugosité des flancs, par rapport à des flancs gravés. L'épitaxie du silicium peut se faire selon différentes épaisseurs e11, e12. Dans cet exemple, le motif 20 s'apparente à un germe mince à partir duquel est formée une portion 21 épaisse. L'épaisseur e11 d'épitaxie selon z est ici de l'ordre de 200 nm. Cela permet d'obtenir une hauteur totale de l'ordre de 220 nm pour la portion 21 de guide d'onde. Cette portion 21 correspond typiquement au cœur du guide d'onde. L'épaisseur e12 d'épitaxie selon y, sur les flancs de gravure lissés, peut être inférieure ou égale à l'épaisseur e11. Selon ce mode de réalisation, l'épitaxie est effectuée sur l'ensemble des faces exposées du motif 20, c'est-à-dire sur le sommet et sur les flancs 200 du motif 20. Un cœur de guide d'onde en ruban peut ainsi être réalisé.

Le topSi présente typiquement un niveau de dopage résiduel. L'épitaxie de silicium est avantageusement réalisée sans ajout de dopants. Le silicium épitaxié de la portion 21 ne présente donc pas de dopage résiduel. Une épitaxie épaisse de silicium, par exemple sur une épaisseur d'épitaxie de l'ordre de 200 nm, sur le germe mince issu du topSi permet avantageusement de former une portion 21 majoritairement dépourvue de dopage résiduel. Il en résulte que les pertes par absorption dans cette portion 21 sont avantageusement minimisées.

La hauteur du germe est donc de préférence la plus faible possible, typiquement inférieure à 10 nm. La largeur du germe est donc de préférence la plus faible possible, typiquement inférieure à 50 nm, voire à 20 nm. Selon une possibilité préférée, les épaisseurs d'épitaxie e11, e12 sont sensiblement égales entre elles. De façon optionnelle, un lissage supplémentaire et/ou une épitaxie supplémentaire de silicium, sur une épaisseur d'épitaxie inférieure à 5 nm peut être effectuée sur la portion 21.

De façon optionnelle, une couche 23 de nitrure de silicium (SiN) d'épaisseur e23 est ensuite formée sur la portion 21 (figure 1E). L'épaisseur e23 de cette couche 23 est typiquement de l'ordre de 20 nm à 30 nm. Le nitrure de silicium (SiN) présente un indice de réfraction de 1.983 pour une longueur d'onde de 1.55 $\mu$m. Le silicium (Si) présente un indice de réfraction de 3.47 pour une longueur d'onde de 1.55 $\mu$m. Le dioxyde de silicium (SiO2), qui est typiquement utilisé pour former la gaine du guide d'onde, présente un indice de réfraction de 1.446 pour une longueur d'onde de

1.55 μm. L'indice de réfraction du SiN est donc compris entre les indices de réfraction du Si et du SiO2. Cela permet de diminuer les pertes par diffusion selon l'équation de Payne-Lacey mentionnée plus haut. Cela permet de limiter les pertes optiques en surface du cœur, entre le cœur et la gaine du guide d'onde.

La couche 23 de nitrure de silicium (SiN) peut être formée par dépôt conforme, par exemple par dépôt chimique en phase vapeur à basse pression LPCVD à une température de l'ordre de 780 °C. Alternativement, la couche 23 de nitrure de silicium (SiN) peut être formée directement par nitruration d'une partie de la portion 21 (figure 1E). Une telle nitruration peut être effectuée sous atmosphère contrôlée avec une concentration d'azote (N) de 100%, à une température de l'ordre de 1200 °C.

Préférentiellement, une encapsulation du cœur est ensuite effectué par une couche d'encapsulation 14 (figure 1F). Cette couche d'encapsulation 14 est de préférence en SiO2. Elle peut être déposée par CVD. Elle permet de former une autre partie de la gaine du guide d'onde. La gaine 24 est ainsi formée tout autour du cœur par les couches 12 et 14 en SiO2. Ce premier mode de réalisation permet de former un guide d'onde 2a en ruban.

Afin de former un guide d'onde 2a en ruban qui soit monomode aux longueurs d'onde utilisées dans les télécommunications (par exemple de l'ordre de 1, 55 μm), le cœur 21 peut présenter une hauteur selon z comprise entre 0, 2 μm et 0, 4 μm, et une largeur selon y comprise entre 0, 2 μm et 0, 4 μm. La partie inférieure de la gaine 24 formée par la couche 12 présente de préférence une hauteur supérieure ou égale à 0, 7 μm dans une configuration de guide d'onde 2a monomode.

D'autres modes de réalisation du procédé selon la présente invention sont envisageables. Ces modes de réalisation peuvent typiquement combiner plusieurs séquences d'étapes comprenant chacune une gravure du silicium suivie d'un lissage des flancs de gravure et d'une épitaxie de silicium. Différentes profondeurs de gravure et différentes épaisseurs d'épitaxie peuvent permettre de former différentes géométries de guide d'onde.

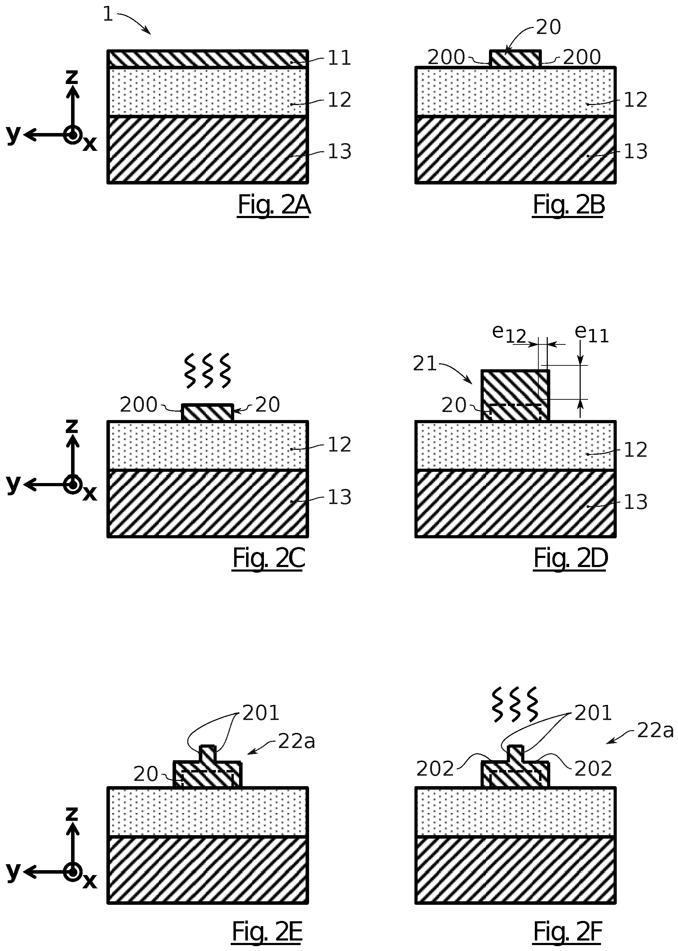

Selon un deuxième mode de réalisation illustré aux figures 2A à 2I, le procédé permet de former un guide d'onde en arête. Seules les étapes différentes du premier mode de réalisation sont décrites ci-après, les autres étapes étant réputées identiques.

A partir d'un substrat de type SOI (figure 2A), une gravure du topSi est effectuée comme précédemment, de manière à obtenir un motif 20 (figure 2B). Un lissage (figure 2C) puis une première réépitaxie (figure 2D) sont effectués sur le motif 20, de façon à former une première portion 21 du guide d'onde.

Une deuxième gravure est ensuite effectuée au niveau de la première portion 21, de manière à former un deuxième motif 22a présentant des flancs 201 de gravure. Ce deuxième motif 22a peut typiquement présenter une section en T inversée, telle qu'illustrée à la figure 2E. Cela permet de fabriquer *in fine* un guide d'onde présentant une géométrie dite « en arête ». La profondeur de la deuxième gravure correspond ici à la hauteur de l'arête, c'est-à-dire la portion en saillie du deuxième motif 22a.

Une deuxième étape de lissage des flancs 201 de gravure est alors effectuée (figure 2F). Cette deuxième étape de lissage est typiquement similaire aux étapes de lissage des flancs de gravure mentionnées précédemment. Elle permet de réduire la rugosité des flancs 201 et des surfaces 202.

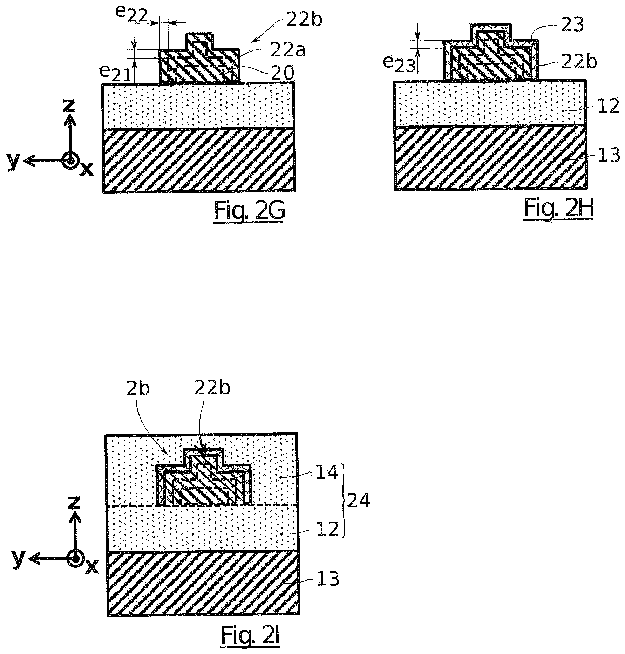

Une deuxième épitaxie de silicium est alors effectuée sur le deuxième motif 22a, de façon à former une deuxième portion 22b du guide d'onde (figure 2G). Cette deuxième portion 22b correspond typiquement au cœur du guide d'onde en arête. La deuxième épitaxie du silicium peut se faire selon différentes épaisseurs e21, e22. Dans cet exemple, l'épaisseur e21 d'épitaxie selon z est de l'ordre de 2 nm à 3 nm. L'épaisseur e22 d'épitaxie selon y est sensiblement égale à l'épaisseur e21. Selon ce mode de réalisation, la deuxième épitaxie est effectuée sur l'ensemble des faces exposées du deuxième motif 22a. Selon une possibilité, les épaisseurs d'épitaxie e21, e22 sont supérieures à 5 nm, voire supérieures à 50 nm.

De façon similaire au premier mode de réalisation, une couche 23 de nitrure de silicium (SiN) peut être formée sur le cœur 22b du guide d'onde (figure 2H). Préférentiellement, une encapsulation du cœur est ensuite effectuée par une couche d'encapsulation 14 (figure 2I).

Ce deuxième mode de réalisation permet de former un guide d'onde 2b en arête. Les guides d'onde fabriqués par le procédé selon la présente invention sont avantageusement utilisables pour des applications LiDAR et télécom 400G longue distance, et pour des applications de photonique quantique et de peigne de fréquences.

L'invention n'est pas limitée aux modes de réalisations précédemment décrits et s'étend à tous les modes de réalisation couverts par les revendications.

En particulier, plusieurs étapes de gravure et/ou de lissage et/ou d'épitaxie peuvent être mises en œuvre pour former le guide d'onde. Dans ce cas, les profondeurs de gravure et/ou les épaisseurs d'épitaxie peuvent varier d'une étape à une autre

**Revendications**

1. Procédé de fabrication d'un guide d'onde (2a, 2b) comprenant :

• Une fourniture d'un substrat (1) comprenant un empilement d'une première couche (11) à base d'un premier matériau sur une deuxième couche (12) à base d'un deuxième matériau, et
• au moins une séquence comprenant successivement :

    i. Une gravure du premier matériau sur toute une épaisseur de la première couche (11), de manière à définir au moins un motif (20) présentant des flancs (200) de gravure,
    ii. Un recuit de lissage assisté par hydrogène de manière à lisser les flancs (200) de gravure de l'au moins un motif (20),
    iii. Une épitaxie du premier matériau sur le motif (20) à base du premier matériau, ladite épitaxie se faisant sur les flancs (200) et un sommet du motif (20).

2. Procédé selon la revendication précédente dans lequel la première couche (11) présente une épaisseur inférieure ou égale à 10 nm.

3. Procédé selon l'une quelconque des revendications précédentes dans lequel l'épitaxie est configurée de manière à ce que le premier matériau épitaxié présente une épaisseur d'épitaxie (e11) supérieure à 100 nm.

4. Procédé selon l'une quelconque des revendications précédentes comprenant au moins une épitaxie supplémentaire du premier matériau sur une épaisseur d'épitaxie (e21, e22) inférieure à 5 nm.

5. Procédé selon l'une quelconque des revendications précédentes dans lequel la première couche (11) présente une épaisseur inférieure ou égale à 10 nm, ledit procédé comprenant une première séquence comprenant :

    • une première gravure du premier matériau sur toute l'épaisseur de la première couche (11) de manière à définir un premier motif (20),
    • un premier lissage des flancs (200) de gravure dudit premier motif (20), et
    • une première épitaxie du premier matériau sur ce premier motif (20), sur une épaisseur d'épitaxie (e11) supérieure à 100 nm, ladite première séquence permettant de former une première portion (21) du guide d'onde (2b),

le procédé comprenant en outre, après la première séquence, une deuxième séquence comprenant :

    • une deuxième gravure de la première portion (21) du guide d'onde (2b) de manière à définir un deuxième motif (22a),
    • un deuxième lissage des flancs (201) de gravure dudit deuxième motif (22a), et
    • une deuxième épitaxie du premier matériau sur ce deuxième motif (22a), sur une épaisseur d'épitaxie (e21, e22) inférieure à 5 nm, ladite deuxième séquence permettant de former une deuxième portion (22b) du guide d'onde (2b).

6. Procédé selon l'une quelconque des revendications précédentes comprenant en outre, après l'au moins une séquence, une formation d'une troisième couche (23) à base d'un troisième matériau sur le premier matériau, ledit troisième matériau présentant un indice de réfraction inférieur à celui du premier matériau et supérieur à celui du deuxième matériau.

7. Procédé selon la revendication précédente dans lequel la troisième couche présente une épaisseur comprise entre 20 nm et 30 nm.

8. Procédé selon l'une quelconque des deux revendications précédentes dans lequel le troisième matériau est un nitrure à base du premier matériau.

9. Procédé selon l'une quelconque des trois revendications précédentes dans lequel ladite formation de la troisième couche (23) comprend un dépôt conforme du troisième matériau.

10. Procédé selon la revendication précédente dans lequel le dépôt conforme du troisième matériau comprend un dépôt chimique en phase vapeur à basse pression (LPCVD).

11. Procédé selon l'une quelconque des revendications 6 à 8 dans lequel ladite formation de la troisième couche comprend une diffusion d'espèces dans le premier matériau à partir d'une atmosphère contrôlée.

**12.** Procédé selon la revendication précédente dans lequel le troisième matériau est un nitrure à base du premier matériau et la diffusion d'espèces dans le premier matériau est une diffusion d'azote à partir d'une atmosphère contrôlée présentant une concentration d'azote supérieure à 80% et de préférence égale à 100%.

**13.** Procédé selon l'une quelconque des revendications 6 à 12 comprenant en outre une encapsulation par une couche d'encapsulation (14) à base du deuxième matériau sur le premier matériau ou sur le troisième matériau.

**14.** Procédé selon l'une quelconque des revendications précédentes dans lequel le premier matériau est du silicium, le deuxième matériau est de l'oxyde de silicium.

Fig. 1A

Fig. 1B

Fig. 1C

Fig. 1D

Fig. 1E

Fig. 1F

Fig. 2A

Fig. 2B

Fig. 2C

Fig. 2D

Fig. 2E

Fig. 2F

e$_{22}$

22b

22a

e$_{21}$

22

20

z

y

x

Fig. 2G

23

e$_{23}$

22b

12

13

z

y

x

Fig. 2H

2b

22b

14

24

12

13

z

y

x

Fig. 2I

Europäisches
Patentamt

European
Patent Office

Office européen
des brevets

**RAPPORT DE RECHERCHE EUROPEENNE**

Numéro de la demande

EP 20 21 5584

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y,D | BELLEGARDE CYRIL ET AL: "Improvement of Sidewall Roughness of Submicron SOI Waveguides by Hydrogen Plasma and Annealing", 2018 IEEE PHOTONICS CONFERENCE (IPC), IEEE, 30 septembre 2018 (2018-09-30), pages 1-4, XP033442228, DOI: 10.1109/IPCON.2018.8527221 * part "II. Experimental setup" * ----- | 1-4,6-14 | INV. G02B6/12 G02B6/122 |
| Y | WO 2011/127840 A1 (SHANGHAI SILIGHT TECHNOLOGY CO LTD [CN]; LI BING [CN]) 20 octobre 2011 (2011-10-20) * pages 1, 6-7 * * figures 5-10 * ----- | 1-4,6-14 | |
| Y | US 2002/176679 A1 (NASHIMOTO KEIICHI [JP]) 28 novembre 2002 (2002-11-28) * alinéas [0017], [0111], [0125] - [0126] * * figures 17A, 17B * ----- | 1-4,6-14 | |
| A | FR 2 845 775 A1 (COMMISSARIAT ENERGIE ATOMIQUE [FR]) 16 avril 2004 (2004-04-16) * page 14 * * figure 6 * ----- | 1-14 | DOMAINES TECHNIQUES RECHERCHES (IPC) G02B |

Le présent rapport a été établi pour toutes les revendications

| Lieu de la recherche | Date d'achèvement de la recherche | Examinateur |
|---|---|---|
| La Haye | 4 mai 2021 | Hohmann, Leander |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 20 21 5584

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

04-05-2021

| Document brevet cité au rapport de recherche | Date de publication | Membre(s) de la famille de brevet(s) | Date de publication |
|---|---|---|---|
| WO 2011127840 A1 | 20-10-2011 | CN 102213795 A<br>WO 2011127840 A1 | 12-10-2011<br>20-10-2011 |
| US 2002176679 A1 | 28-11-2002 | JP 2002350659 A<br>US 2002176679 A1 | 04-12-2002<br>28-11-2002 |
| FR 2845775 A1 | 16-04-2004 | FR 2845775 A1<br>WO 2004034092 A2 | 16-04-2004<br>22-04-2004 |

EPO FORM P0460

Pour tout renseignement concernant cette annexe : voir Journal Officiel de l'Office européen des brevets, No.12/82

**RÉFÉRENCES CITÉES DANS LA DESCRIPTION**

**Littérature non-brevet citée dans la description**

- **C. BELLEGARDE et al.** Improvement of sidewall roughness of submicron SOI waveguides by hydrogen plasma and annealing. *IEEE Photonics Technology Letters,* Avril 2018, vol. 30 (7), 591-594